# EUROPEAN PATENT APPLICATION

(11) **EP 0 814 511 A2**
(43) Date of publication of application: **29.12.1997**
(21) Application number: 97304020.7
(22) Date of filing: 10.06.1997
(51) Int. Cl.: H01L 23/498, H01L 23/13

(54) **Plastic ball grid array module**

(30) Priority: 19.06.1996 GB 9612769
(71) Applicant: INTERNATIONAL BUSINESS MACHINES CORPORATION, Armonk, NY 10504 (US)
(72) Inventor: Garbelli, Francesco, 20043 - Arcore, Milan (IT); Oggioni, Stefano, 20059 - Vimercate, Milan (IT)
(74) Representative: Zerbi, Guido Maria

(57) **Abstract**

A Plastic Ball Grid Array electronic package having the conductive metal pads of variable area. The central pads are wider than those closer to the border for compensating the warpage effect on the final package.

## Description

The present invention relates to Printed Circuit Boards (PCB) and more particularly to PCB for use in the manufacturing of Ball Grid Array (BGA) electronic modules.

The recent development of the technology introduced the use of organic Printed Circuit Board (PCB) laminates as substrate for the manufacturing of electronic modules which can be of the Single Chip Module (SCM) type or Multi Chip Module (MCM) type. This modules are provided with a plurality of conductive pads for the electrical connection with electronic circuits (such as mother boards, back planes, application boards). The electrical connection is achieved by little spherical portions of solder alloy which give the name of Ball Grid Array (BGA) to this kind of electronic module. These modules are usually called Plastic Ball Grid Array. The definition "Plastic" indicates the flexible nature of the PCB as opposed to a ceramic substrate.

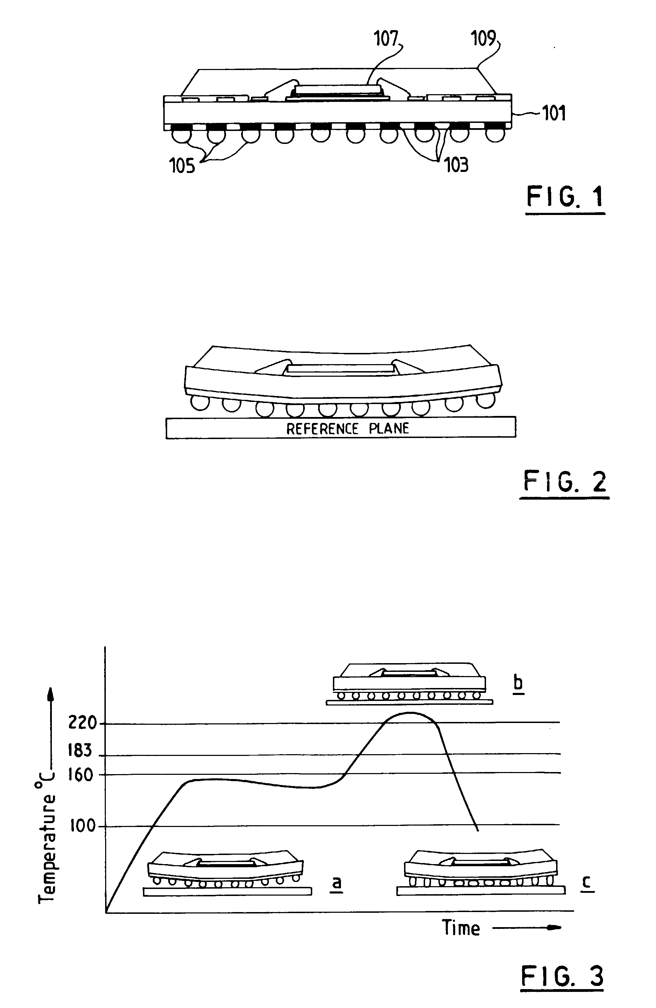

Fig. 1 is an example of a section of a BGA module of the SCM type. On the lower face of the laminate 101 there is a plurality of conductive pads 103 each pad provided with a solder ball 105 which will be put in contact with an electronic circuit and reflowed, thereby realizing the electrical connection. On the upper face of the module there is the active element 107 covered by a moulded cap 109 which protects the active element.

The Plastic BGA technology has a number of advantages over the traditional technologies such as the Pin Grid Arrays in terms, for example, of reliability, robustness and cost of manufacturing. However some problems are still to be solved. A drawback of the Plastic BGA modules is the so called package warpage as discussed at the IPC Printed Circuit Expo and 39th Annual Meeting on 3 March in San Jose, California, in a session entitled "Packaging for the 90s: an Overview" (reported in Circuit World Journal of the Institute of Circuit technology and Technical Journal of the Printed Circuit and Interconnection Federation, Volume 22 No. 3, 1996).

This warpage is mainly due to the difference of the Coefficient of Thermal Expansion (CTE) between the different materials used for the Plastic BGA modules during manufacturing. These material dependent CTEs affect the module behaviour in the different process steps starting from the assembly down to the mounting of the module on the application boards.

Materials used for Plastic BGA modules range from organic composites (laminate with medium-high CTE) to silicon (active device with low CTE) with a wide utilisation of resin (epoxy, acrylic, urethane and other, all having a high CTE).

In the BGA module manufacturing process, after having mounted the active silicon element on the laminate substrate a final enclosure 109 (Fig.1) is placed on the module. This cover is necessary for protecting the active device 107 from external environment and to supply a surface suitable for high speed "pick and place" equipments for the moving and positioning of the modules. At present there are two methods which are commonly used: the Blob Top (also called Glob Top) method and the Overmolding method. With Blob Topping a fluid resin is dispensed at relatively low temperature, usually lower than 90 C. With Overmolding the resin is injected by pressure in a cast at high temperature, usually around 180 C.

Anyway the temperature at which the resins are dispensed is higher than the utilisation temperature and both the methods are using materials which reduce their volume after polymerisation. This means that the temperature decrease causes a shrinkage of the resins. Another aspect to be considered is that the dispensed or injected materials are present on one side of the module only.

For the above reasons the resin shrinkage determines a tension build up in the module when it is cooled from the processing temperature down to the room temperature; the module at the end of the assembly process presents a deformation with the four corners of the laminate lifted with respect to the centre. This is the above mentioned package warpage which affects the value of coplanarity of the module balls as shown in Fig. 2. This "four corners up" shape is determined by the presence of the silicon element, which acts as a stiffener in area where it is glued or soldered to the substrate laminate; on the contrary the laminate, being more flexible where no silicon element is present, yields to the resin shrinkage induced forces.

This warpage can cause serious problems during the reflow process for soldering the package to application boards, or during the life of the module. Even if all the balls are soldered with the proper contacts, it should be evident that the outer balls are subject to a strength which can affect their solidity. If one of the contacts remains open, this usually means that the Plastic BGA package is compromised and the process should be restarted; hand reworking is very difficult (when not impossible) and hand reworked ball-joints have not been proved to be reliable.

When a module is exposed to a thermal cycle that reaches or goes beyond the original resin dispensing/injection temperature, the warpage tends to reduce and theoretically to disappear.

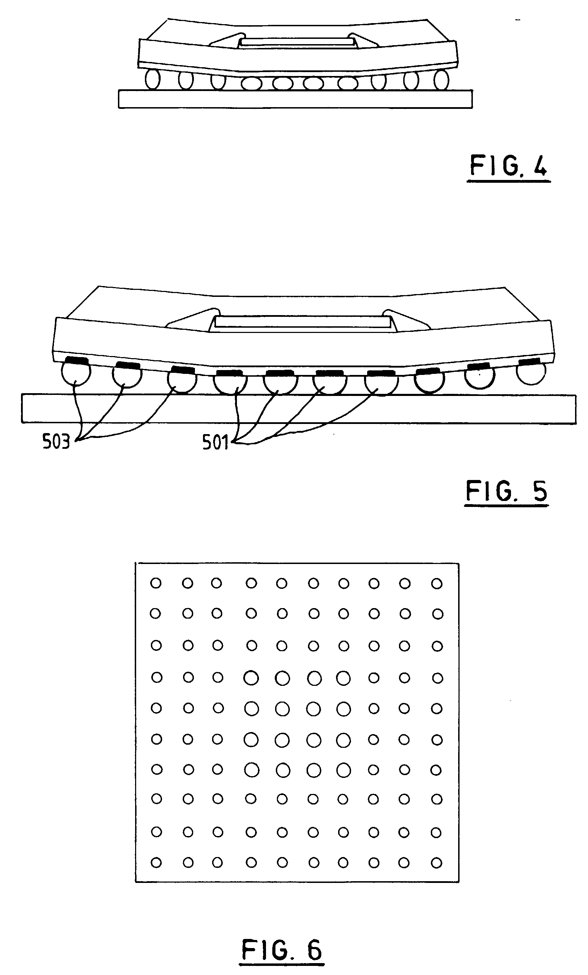

Fig. 3 shows an example of a possible reflow profile for the attachment of a module (of the SCM type as the one shown in Fig. 1) to an application substrate and the Temperature related module behaviour. During the reflow the solder alloy balls collapse in height and simultaneously the module tends to lose the warpage described above. This is due to the fact that the volume of the resin cap (which has a high CTE) substantially increases with the increase of the Temperature. These conditions allow the balls to join the contact on the application substrate (Fig. 3.b). When temperature decreases again the resin shrinkage (and the consequent warpage) causes an upward force on the border of the module which tend to deform the outer solder balls before they completely re-solidify. So, even in the best assumption that none of the balls breaks, we obtain different joint shapes according to the position on the module. The cross section of Fig. 4 schematically shows these different shapes in the case of a SCM module. The solder balls result to be low and fat in the central area, where the silicon device is attached to the plastic laminate, and higher and less round shaped towards the edges of the module. The solder joint are therefore subject to different stress rates either at room temperature or during the product life time power on/off cycling.

For the above reasons the warpage in the electronic package is a felt and well known problem. An international specialized organization, the JEDEC (Joint Electron Device Engineering Council) indicates in 150µm the ideal maximum δ in the coplanarity value at the edges with respect to the centre a Plastic BGA module should have for limiting the harmful consequences of the warpage effects on the final package. This value is very severe if considering that it is independent of the size of the module and the known manufacturing technologies cannot guarantee its observance.

The present invention has the object to provide a technique which overcomes the above drawbacks.

According to the present invention, we provide a printed circuit board (PCB) for use in the manufacturing of Ball Grid Array electronic modules, the PCB having on a first face a plurality of conductive metal pads connectable with a plurality of substantially spherical portions of solder alloy, characterised in that the pads have variable surface area.

Further, according to the present invention, we provide a Plastic Ball Grid Array module comprising a PCB, the PCB having on a first face a plurality of conductive metal pads connectable with a plurality of substantially spherical portions of solder alloy, the pads having variable surface area, and the PCB having on a second face a conductive layer connected to the plurality of pads, the conductive layer being connectable to at least one electronic element.

The above and other advantages of the present invention will be better understood with reference to the following figures, where:
Figure 1 is a schematic representation of a prior art BGA module;
Figure 2 is a schematic representation of the warpage effect on a Plastic BGA module;
Figure 3 is a schematic representation of the behaviour of a Plastic BGA module during the reflow process;
Figure 4 is a schematic representation of the deformation of the solder balls in a Plastic BGA module due to the warpage effect;
Figure 5 is a cross section of a preferred embodiment of the present invention;
Figure 6 is a plane view of the differentiated geometry of the metal pads of a Plastic BGA module, according to a preferred embodiment of the present invention.

Plastic BGA modules can be assembled essentially with two processes, with or without adding solder paste for the joint formation between the module balls and the application substrate surface. In both cases, anyway, the "four corners up" shape of the module can determine a severe yield impact on the final result of the assembly operation.

In the case of an assembling process with addition of solder paste, a eutectic solder paste (usually a Tin-Lead alloy) is dispensed on the application surface by screen-printing; the BGA module is then usually placed with a "pick and place" machine over the screened paste. The amount and the thickness of the screened paste can be varied to compensate the warpage of the module; however this technique is effective only for little deviations in the co-planarity of the balls. Also it should be noted that on a single application surface different components can be mounted each one having different needs and the amount of solder paste has to be a compromise given all these needs.

In the case of an assembling process without any solder paste, the BGA module is placed directly on the metal pads of the application boards and only the central balls are in straight contact. The external ones are spaced due to the above described warpage. Another risk, even worse than the described deformation of solder balls after reflowing, is possible: that the module "tilts" on one of its sides leaving completely open the contacts on the opposite sides.

According to the present invention, the metal pads present on the lower face of the module, to which the solder balls are attached, have differentiated geometry according to their position on the module.

In a preferred embodiment the metal pads have two different dimensions. The presence or not of silicon devices in correspondence of the pads is preferably used as a "gating factor". While considering a module of the SCM type (i.e. having only one silicon chip, usually in the centre) the metal pads will have a wider area in the centre, and a smaller area near the edges of the module.

This differentiated geometry counteracts the natural deformation of the module, balancing the effects of the package warpage.

Fig.5 is a cross section of a Plastic BGA module with respect to a reference plane, showing an example of the differentiated geometry of the metal pads and the reduced warpage effect it causes to the module. The four central pads 501 have a wider area than the pads 503 which are closer to the edge.

When the solder balls are attached to the metal pads, the central balls, having a wider contact area to wet, will distribute over the whole pad and the result will be a decreased height of the final ball. This will allow the outer pads, which due to the effect of the warpage were spaced from the reference plane, to decrease the δ in the coplanarity value and to balance the negative effect of the warpage.

An additional result reached with this differentiated geometry, is that, when the module is reflowed on an application board, the joint with wider pads (in our example the central ones) will show an increased robustness due to the wider soldered area.

Fig. 6 is an example of distribution of pads with two different sizes on a Plastic BGA module. It shows a bottom plane view, where the 4x4 central pads are wider than the external ones. This is because the example refers to a Plastic BGA module of the SCM type (i.e. with only one active silicon element). Of course different kind of electronic modules may cause different distributions of the pads. In a preferred embodiment the pads are circular and the area of the central pads is 25% more than the other pads.

Of course other distributions, shapes and ratios are possible (e.g. more than two different dimensions for the pads) which better fit the needs of particular modules. However, even with this simple double size of the pads, it has been proved that the deviation δ in the coplanarity of the balls with respect to a reference plane in a plastic BGA module can be maintained within the above mentioned threshold of 150µm suggested by JEDEC (Joint Electron Device Engineering Council).

## Claims

1. A printed circuit board (PCB) for use in the manufacturing of Ball Grid Array electronic modules, the PCB having on a first face a plurality of conductive metal pads connectable with a plurality of substantially spherical portions of solder alloy, characterised in that the pads have variable surface area.

2. The PCB of claim 1 wherein the plurality of conductive metal pads includes at least a first set of pads having a first surface area and at least a second set of pads having a second surface area.

3. The PCB of claim 2 wherein the first set of pads is placed in a first portion of the PCB and the second set of pads is placed on a second portion of the PCB.

4. The PCB of claim 3 wherein the first portion is located in the centre of the PCB and the second portion is located around the first portion.

5. The PCB of claim 2, 3 or 4 wherein the first surface area is larger than the second surface area.

6. The PCB of claim 5 wherein the first surface area is 25% larger than the second surface area.

7. The PCB of any preceding claim having an organic substrate.

8. The PCB of any preceding claim, having on a second face a conductive layer connected to the plurality of pads, the conductive layer being connectable to at least one electronic element.

9. A Plastic Ball Grid Array module comprising the PCB of claim 8.

10. The Plastic Ball Grid Array of claim 9 wherein the first area is located in correspondence with the at least one electronic element.
